## Europäisches Patentamt

## European Patent Office

## Office européen des brevets

(19)

(11) Numéro de publication: **0 227 561**
B1

(12)

# FASCICULE DE BREVET EUROPEEN

(45) Date de publication du fascicule du brevet:
18.07.90

(51) Int. Cl.⁵: **H01L 21/312**, G03F 7/26

(21) Numéro de dépôt: 86420279.1

(22) Date de dépôt: 19.11.86

(54) Procédé de gravure de matériaux organiques par plasma.

(30) Priorité: 21.11.85 FR 8517486

(43) Date de publication de la demande:
01.07.87 Bulletin 87/27

(45) Mention de la délivrance du brevet:
18.07.90 Bulletin 90/29

(84) Etats contractants désignés:
DE FR GB IT NL

(56) Documents cités:
US-A- 4 407 850

JOURNAL OF THE ELECTROCHEMICAL SOCIETY,
vol. 130, no. 3, mars 1983, page 83C, résumé
no. 176, Manchester, New Hampshire, US; F.Y. ROBB:
"Hydrogen-plasma etching of organic films"
JOURNAL OF THE ELECTROCHEMICAL SOCIETY,
vol. 131, no. 7, juillet 1984, pages 1670-1674, Manchester, New Hampshire, US; F.Y. ROBB: "Hydrogen
plasma etching of organics"
IBM TECHNICAL DISCLOSURE BULLETIN,
vol. 26, no. 6, novembre 1983, pages 2688-2689, New
York, US; S.J. GILLESPIE: "Resist process mask"

(73) Titulaire: Pons, Michel, 4 Résidence Les Léchères
Avenue de la Plaine Fleurie, F-38240 Meylan(FR)
Titulaire: Moschini, Philippe, 22, Boulevard Maréchal
Leclerc, F-38000 Grenoble(FR)
Titulaire: Henry, Daniel, Chemin des Combes, F-38700 Le
Sappey en Chartreuse(FR)

(72) Inventeur: Pons, Michel, 4 Résidence Les Léchères
Avenue de la Plaine Fleurie, F-38240 Meylan(FR)
Inventeur: Moschini, Philippe, 22, Boulevard Maréchal
Leclerc, F-38000 Grenoble(FR)
Inventeur: Henry, Daniel, Chemin des Combes,
F-38700 Le Sappey en Chartreuse(FR)

(74) Mandataire: de Beaumont, Michel, 1bis, rue
Champollion, F-38000 Grenoble(FR)

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit
être formée par écrit et motivée. Elle n'est réputée formée qu'après paiement de la taxe d'opposition (Art. 99(1) Convention sur le
brevet européen).

ACTORUM AG

**Description**

La présente invention concerne un procédé de gravure de matériaux organiques par plasma et plus particulièrement de matériaux organiques couramment désignés sous l'appellation résine destinés à former des motifs sur les surfaces de tranches semiconductrices auxquelles on veut faire subir des traitements particuliers selon ces motifs, ces traitements particuliers étant par exemple des gravures, des dopages ou autres.

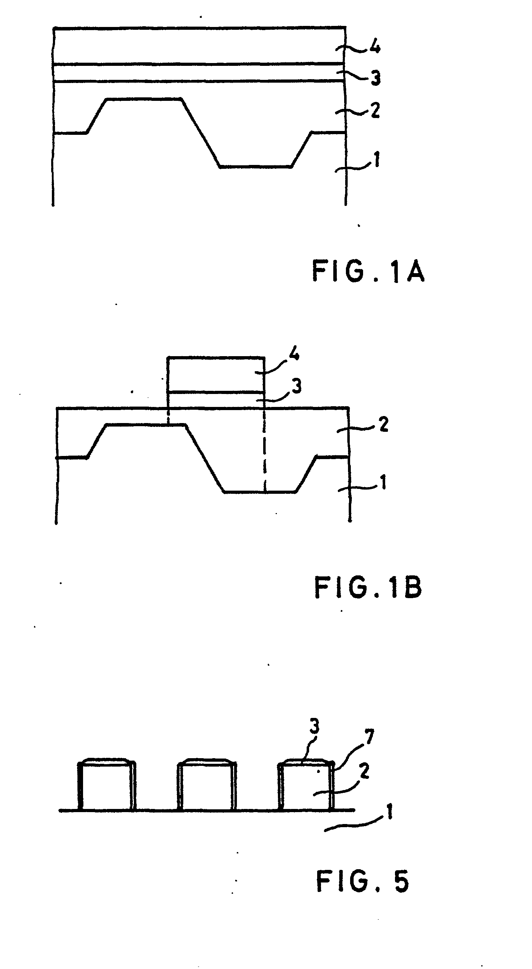

La figure 1A représente la surface supérieure 1, non plane, d'une tranche semiconductrice ayant déjà subi les traitements préalables et devant subir un nouveau traitement localisé. Comme cela est classique, pour délimiter les zones dans lesquelles devront être effectués les nouveaux traitements, dans le cas où l'on veut former des motifs de l'ordre du micromètre, on opère à l'aide d'un système tricouche. Une première couche 2 de résine photosensible ou non est déposée à la tournette pour obtenir une surface lisse. Cette première couche pourra être une couche du produit dit HPR 204 N° 2 et avoir une épaisseur de l'ordre de 1,5 à 2 micromètres. Ensuite, est formée une couche mince 3 d'une substance minérale, par exemple un composé oxygéné $SiO_x$ de silicium ou un nitrure de silicium tel que $Si_3N_4$. On forme ensuite une couche de résine photosensible 4. Après cela, comme le représente la figure 1B, on commence par graver par photolithographie la couche 4 puis, en se servant de cette couche 4, on grave la couche sous-jacente 3. Après cela, il faut graver la couche épaisse de résine 2 selon un profil aussi rectiligne, verticalement, que possible, c'est-à-dire de façon aussi anisotrope que possible. Il faut donc utiliser un procédé qui permette une forte sélectivité d'attaque entre la couche minérale 3 et la couche organique 2, ce procédé permettant en outre d'obtenir une forte anisotropie de gravure pour la couche 2. Ce procédé doit être aussi rapide que possible, c'est-à-dire que la vitesse d'attaque, couramment exprimée en nanomètres (nm) par minute (mn), doit être aussi élevée que possible pour satisfaire les exigences de fabrication industrielle.

A ce jour, un tel procédé n'existe pas. Si l'on considère de façon générale les procédés de gravure fortement anisotropes on est amené à s'intéresser aux procédés de gravure par plasma (gravure ionique réactive) souvent désignés par le sigle anglosaxon RIE (Reactive Ionic Etching) et aux perfectionnements apportés à ces procédés mis en oeuvre dans des appareils aujourd'hui commercialement disponibles dits "réacteurs grande vitesse haute pression" commercialisés par de nombreuses sociétés telles que C.I.T. Alcatel, Tegal, Perkin Elmer, etc.

Les essais faits dans la technique antérieure pour graver des résines de façon sélective par rapport à une couche telle que la couche 3 décrite précédemment dans un réacteur classique (RIE) ont donné des résultats satisfaisants avec des gravures à l'oxygène mais alors les vitesses de gravure étaient faibles (inférieures à 100 nm/mn).

On a donc essayé d'utiliser pour accélérer la vitesse, comme cela était logique, un réacteur grande vitesse haute pression. Avec comme gaz actif de l'oxygène, on a bien obtenu des vitesses de gravure importantes mais la caractéristique d'anisotropie était perdue et, si l'on voulait graver une nervure dans une couche de résine, on arrivait à des formes en champignon (partie supérieure plus large que la partie inférieure). Diverses tentatives ont également été effectuées avec l'hydrogène sans résultat satisfaisant en ce qui concerne la vitesse de gravure.

La gravure de matériaux organiques par plasma utilisant de l'hydrogène et de l'argon est connue de J. Electrochem. Soc. vol. 131, no. 7, July 1984, p. 1670–1674.

Ainsi, un objet de la présente invention a été de développer un nouveau produit d'attaque donnant des caractéristiques satisfaisantes de vitesse et d'anisotropie pour graver une couche de résine.

Cet objet a été atteint selon la présente invention en prévoyant un procédé de gravure de matériaux organiques par plasma utilisant un réacteur à grande vitesse haute pression dans des conditions normales, procédé dans lequel on introduit dans le réacteur de l'hydrogène et de l'argon, le débit d'argon étant au moins trois fois supérieur au débit d'hydrogène et de préférence de trois à cinq fois supérieur.

Pour améliorer encore le procédé il s'est avéré qu'il était souhaitable d'ajouter au mélange argon/hydrogène quelques pour cent en débit d'oxygène ou d'azote.

Les caractéristiques du procédé selon l'invention et les résultats obtenus seront indiqués ci-après en relation avec les figures jointes parmi lesquelles:

les figures 1A et 1B ont été décrites précédemment et étaient destinées à présenter le problème posé;

la figure 2 indique les variations de vitesse de gravure obtenues par le procédé selon la présente invention quand le débit d'argon varie par rapport au débit d'hydrogène;

la figure 3 indique les variations de vitesse de gravure obtenues par le procédé selon la présente invention quand le débit d'hydrogène varie, le rapport entre le débit d'argon et le débit d'hydrogène étant maintenu constant;

la figure 4 indique les variations de vitesse de gravure par rapport à la puissance par unité de surface dans le réacteur, toutes choses égales d'ailleurs;

la figure 5 illustre des résultats obtenus par le procédé selon la présente invention.

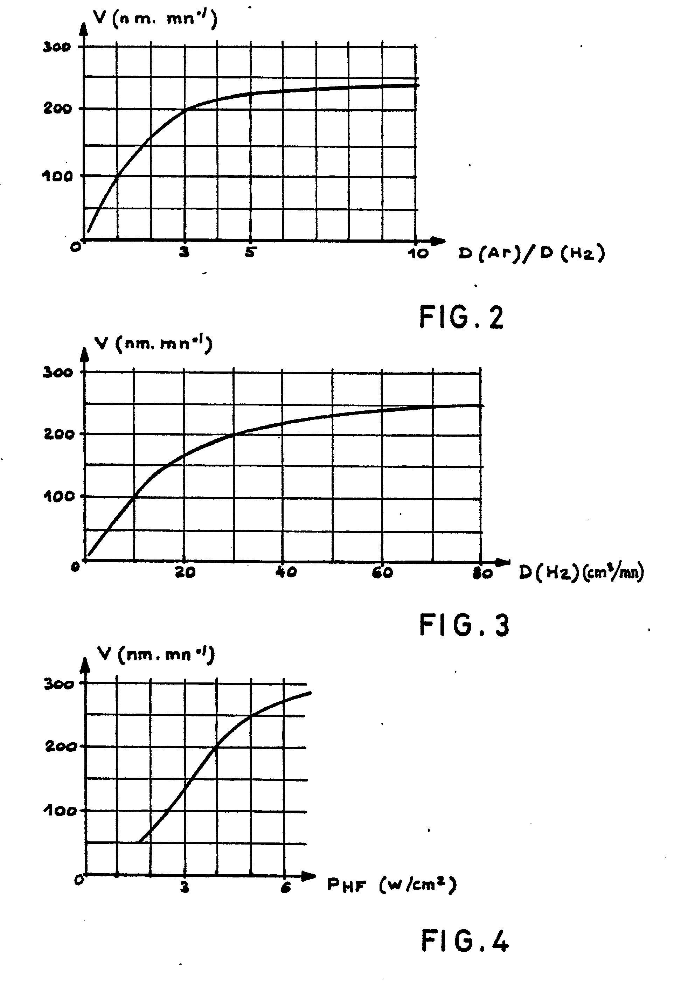

Les figures 2 à 4 représentent diverses résultats expérimentaux obtenus avec une couche 2 de résine de type HPR 204 dans un réacteur grande vitesse haute pression commercialisé par la société C.I.T. Alcatel avec des mélanges variables d'hydrogène et d'argon.

La figure 2 représente la vitesse de gravure en nm/mn pour un débit d'hydrogène dans le réacteur de 33 cm³/mn, une pression de 77 Pa (0,77 millibar) et une puissance haute fréquence par unité de surface de 4,4 W/cm². On voit que la vitesse de gravure commence à saturer dès que le rapport entre le débit d'argon et le débit d'hydrogène atteint une valeur de l'ordre de 3. On peut donc considérer que la plage optimale, si l'on ne veut pas augmenter excessivement les débits, est comprise entre trois et cinq pour le rapport du débit d'argon au débit d'hydrogène ($D(Ar)/D(H_2)$).

La figure 3 représente la variation de vitesse de gravure en nm/mn en fonction du débit d'hydrogène, en cm³/mn, le rapport entre le débit d'argon et le débit d'hydrogène étant maintenu constamment égal à 4, la pression dans l'enceinte étant toujours maintenue à 0,77 millibar et la densité de puissance PHF à 4,4 W/cm². On voit que, dès que l'on atteint un débit d'hydrogène de l'ordre de 33 cm³/mn, on ne gagne plus beaucoup à augmenter ce débit. C'est pourquoi la valeur de 33 cm³/mn pour le débit d'hydrogène a été choisie dans le cas de la figure 2.

La figure 4 représente, dans les conditions optimales de débit sélectionnées par suite des résultats indiqués en figures 2 et 3, la variation de vitesse de gravure en nm/mn en fonction de la densité de puissance haute fréquence dans le réacteur en W/cm². On voit que le phénomène tend à se saturer dès que la densité de puissance dépasse 4 W/cm². Il est donc souhaitable de se maintenir au voisinage de cette valeur pour éviter d'accroître les phénomènes d'échauffement des plaquettes et de pulvérisation (par bombardement ionique) de la couche 3.

Enfin, des mesures de variation de vitesse de gravure en fonction de la pression dans l'enceinte indiquent que la vitesse de gravure est pratiquement constante pour des pressions variant de 0,5 mbar à plus de 3 mbars.

La figure 5 représente schématiquement des résultats obtenus par suite de la mise en oeuvre de la présente invention. Ce shéma est reconstitué à partir de photos effectués sur des structures obtenues expérimentalement. On peut voir en figure 5, sur un substrat 1, une couche de résine 2 d'une épaisseur de l'ordre de 1,5 micromètres revêtue d'une couche de nitrure de silicium 3 d'une épaisseur de quelques dixièmes de micromètre. On s'aperçoit que l'on obtient une gravure parfaitement anisotrope (la sous-gravure est inférieure à 0,1 micromètre) et, en outre, qu'il se forme sur le flanc des nervures sculptées dans la couche de résine des dépôts 7 d'une épaisseur de l'ordre du dixième de micromètre ; ce dépot, ou plutôt ce redépôt, formé en cours de gravure évite justement les sous-gravures des couches déjà gravées et assure une bonne anisotropie du phénomène.

En fait, les expériences effectuées montrent que le risque est que ce redépôt devienne trop important. Des expériences ont montré que l'on pouvait arriver à contrôler l'épaisseur du redépôt en ajoutant au mélange hydrogène/argon précédemment décrit un faible pourcentage d'oxygène ou d'azote. Ainsi, selon la résine particulière que l'on souhaite graver, quelques essais simples indiqueront s'il y a lieu de rajouter de l'oxygène ou de l'azote et, si oui, dans quelle proportion. A titre indicatif, on notera que le débit d'oxygène ou d'azote par rapport au débit d'ensemble argon plus hydrogène doit être de l'ordre de 1 à 10%. Si ce débit est trop important, on enlève complètement la couche de redépôt et alors une isotropie apparaît.

## Revendications

1. Procédé de gravure de matériaux organiques par plasma utilisant un réacteur grande vitesse haute pression dans des conditions normales, procédé dans lequel on introduit dans le réacteur de l'hydrogène et de l'argon, caractérisé en ce que le débit d'argon est au moins trois fois supérieur au débit d'hydrogène.

2. Procédé selon la revendication 1, caractérisé en ce que le débit d'argon est de trois à cinq fois supérieur au débit d'hydrogène.

3. Procédé selon la revendication 1, caractérisé en ce que l'on introduit en outre dans le réacteur de l'oxygène dans une proportion en débit de quelques pour cent par rapport au débit d'argon et d'hydrogène.

4. Procédé selon la revendication 1, caractérisé en ce que l'on introduit en outre dans le réacteur de l'azote dans une proportion en débit de quelques pour cent par rapport au débit d'argon et d'hydrogène.

## Patentansprüche

1. Verfahren zum Plasmaätzen von organischen Stoffen unter Verwendung eines Hochgeschwindigkeits- und Hochdruck-Reaktors unter Normalbedingungen, wobei in den Reaktor Wasserstoff und Argon eingegeben werden, dadurch gekennzeichnet, daß die Argonzugabe mindestens dreimal größer als die Wasserstoffzugabe ist.

2. Verfahren nach Anspruch 1, dadurch gekennzeichnet, daß die Argonzugabe drei- bis fünfmal größer als die Wasserstoffzugabe ist.

3. Verfahren nach Anspruch 1, dadurch gekennzeichnet, daß ferner dem Reaktor Sauerstoff mit einem Zugabeanteil von einigen Prozent, gemessen an der Argon- und Wasserstoffzugabe, zugeführt wird.

4. Verfahren nach Anspruch 1, dadurch gekennzeichnet, daß dem Reaktor Stickstoff mit einem Zugabeanteil von einigen Prozent, gemessen an der Argon- und Wasserstoffzugabe, zugeführt wird.

## Claims

1. A method for plasma eatching organic materials using a high pressure, high speed reactor in usual conditions, wherein hydrogen and argon are introduced in the reactor, characterized in this that the argon flow is at least three times higher than the hydrogen flow.

2. A method according to claim 1, characterized in this that the argonflow is from three to five times higher than the hydrogen flow.

3. A method according to claim 1, characterized in this that oxygen is further introduced in the reactor according to a flow proportion of some per cents with respect to the argon and hydrogen flow.

4. A method according to claim 1, characterized in this that nitrogen is further introduced in the reactor according to a flow proportion of some per cents with respect to the argon and hydrogen flow.

FIG . 1A

FIG.1B

FIG . 5

FIG. 2

FIG. 3

FIG. 4